(19) Europäisches Patentamt
European Patent Office
Office européen des brevets

(11) **EP 3 913 520 B1**

(12) **EUROPEAN PATENT SPECIFICATION**

(45) Date of publication and mention of the grant of the patent:
**16.04.2025 Bulletin 2025/16**

(21) Application number: **20904296.9**

(22) Date of filing: **13.06.2020**

(51) International Patent Classification (IPC):
**G06F 30/17** (2020.01)   **F01D 5/14** (2006.01)

(52) Cooperative Patent Classification (CPC):
**F01D 5/141; F04D 27/001; F04D 29/324;**
F05D 2240/301; F05D 2250/74; F05D 2260/80;
G06F 30/15; G06F 30/17

(86) International application number:
**PCT/CN2020/095986**

(87) International publication number:
**WO 2021/196407 (07.10.2021 Gazette 2021/40)**

(54) **AVIATION BLADE PROFILE CHORD LENGTH MEASUREMENT METHOD AND SYSTEM BASED ON SECANT ROTATION ITERATION**

VERFAHREN UND SYSTEM ZUR BESTIMMUNG UND BERECHNUNG DER PROFILSEHNENLÄNGE EINER FLUGZEUGTRIEBWERKSSCHAUFEL BEI SEKANTENROTATIONSWIEDERHOLUNG

PROCÉDÉ ET SYSTÈME DE MESURE DE LONGUEUR DE CORDE DE PROFIL DE PALE D'AVIATION BASÉS SUR UNE ITÉRATION DE ROTATION SÉCANTE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.03.2020 CN 202010233826**

(43) Date of publication of application:
**24.11.2021 Bulletin 2021/47**

(73) Proprietor: **Huazhong University of Science and Technology**
**Wuhan, Hubei 430074 (CN)**

(72) Inventors:
• **LI, Wenlong**
**Wuhan, Hubei 430074 (CN)**
• **XU, Wei**
**Wuhan, Hubei 430074 (CN)**
• **JIANG, Cheng**
**Wuhan, Hubei 430074 (CN)**
• **JIN, Fuquan**
**Wuhan, Hubei 430074 (CN)**
• **FEN, Sheng**
**Wuhan, Hubei 430074 (CN)**
• **DING, Han**
**Wuhan, Hubei (CN)**

(74) Representative: **Straus, Alexander**
**2K Patentanwälte - München**
**Bajuwarenring 14**
**82041 Oberhaching (DE)**

(56) References cited:
CN-A- 101 169 047    CN-A- 102 735 204
CN-A- 107 806 836    CN-A- 110 489 939
CN-A- 110 781 573    US-A1- 2007 025 855
US-A1- 2008 101 959    US-A1- 2017 314 530

• PENG ZHIGUANG, LI WEN-LONG: "Feature Parameters Extraction of theBlade Surface based on the Improved Convex Hull Algorithm", EQUIPMENT MANUFACTURING TECHNOLOGY, no. 1, 15 January 2012 (2012-01-15), XP055854938, ISSN: 1672-545X

## Description

### TECHNICAL FIELD

The present invention relates to the field of profile inspection of an aero-engine blade, and in particular to a method and system for determining and calculating a profile chord length of an aero-engine blade based on secant rotation iteration.

### BACKGROUND

An aero-engine blade is a core component of an aero-engine. The aero-engine blade works under the severe conditions of high temperature, high pressure and fluctuating load for a long time. The manufacturing precision of the aero-engine blade directly affects the performance of the aero-engine, so that it is necessary to inspect and control the profile quality of the aero-engine blade. As the chord length is the key parameter of an aero-engine blade profile, it is particularly important to calculate the chord length accurately.

When the chord length is directly measured, it is difficult to determine the position of a chord line and ensure the tangency of a pressure surface side and the leading and trailing edges and there are too many parameters to be measured, directly resulting in low measurement efficiency.

During blade determination on a large scale, for the consideration of precision and efficiency, the profile chord length of the aero-engine blade is calculated at present generally based on a method for creating a convex hull of a blade profile. However, a convex hull structure is complex and for an aero-engine blade with a small radius of the leading edge and the trailing edge, it is possible to directly delete part of measuring points since the leading and trailing edge measuring points are close. As a result the created convex hull structure is wrong, causing calculation errors of the chord length.

The size of the blade can be controlled by the chord length of the blade. If the chord length is too short, the strength of the blade is reduced, affecting the impact resistance and the aerodynamic performance of the blade. Therefore, the prior art as described in US2007/025855 has the technical problem that the aerodynamic performance and safety of the blade cannot be ensured due to numerous calculation errors in the determination of the chord length.

### SUMMARY

For the above defects or improvement requirements in the prior art, the present invention provides a method and system for determining and calculating a profile chord length of an aero-engine blade based on secant rotation iteration, thereby solving the technical problem that the aerodynamic performance and safety of the blade cannot be ensured due to numerous calculation errors of the chord length in the prior art.

To achieve the above objective, according to one aspect of the present invention, a method for determining and calculating a profile chord length of an aero-engine blade based on secant rotation iteration is provided. The method includes the following steps:

(1) taking a connection line between two most distant points in a blade profile measuring point set as a secant, and rotating or translating the secant to enable the secant to intersect with a pressure surface, thus obtaining a leading edge point set and a trailing edge point set; and

(2) rotating the secant in a range of the leading edge point set and the trailing edge point set to obtain tangent points of the secant and the leading and trailing edges, and calculating a distance between the two tangent points to obtain a chord length.

The method further includes: :
comparing the chord length calculated in step (2) with a standard chord length, wherein when a difference between the chord length and the standard chord length is less than a preset value, the aerodynamic performance and safety of the blade meet the requirements. wherein step (2) comprises: (21) sorting the leading edge point set according to a distance between points in the leading edge point set and the straight line, and sorting the trailing edge point set according to a distance between points in the trailing edge point set and the straight line; (22) fixing an endpoint of the secant, and sequentially rotating the secant according to a sorting result in the trailing edge point set to obtain a tangent point of the secant and the trailing edge; and (23) fixing the tangent point of the secant and the trailing edge, sequentially rotating the secant according to a sorting result in the leading edge point set to obtain a tangent point of the secant and the leading edge, and calculating a distance between the two tangent points to obtain a chord length; wherein in the step (1) of rotating or translating the secant to enable the secant to intersect with the pressure surface, is specifically implemented as follows: substituting coordinates $(x_i, y_i)$ of any point $P_i$ in the blade profile measuring point set into a linear equation of the secant to obtain $S_i = (Y_b - Y_a) Cx'_i - x_\alpha) + (x_a - x_b)(y_i - y_\alpha)$, wherein $(x_a, y_a)$ and $(X_b, Y_b)$ are two endpoints of the secant, and SLis a value obtained by substituting Pi into the linear equation; comparingSL with a threshold $\delta s$, and when SL is less than the threshold $\delta s$, takingpias the intersection point of the blade profile; intersection points of the secant and the blade profile being 2 or 3 or 4; when there are 4 intersection points of the secant and the blade profile, two middle points when the four intersection points are connected are the intersection points of the secant and the pressure surface; when there are 3 intersection points of the secant and the blade profile, rotating the secant to obtain the intersection point of the secant and the pressure surface; and when there are 2 intersection points of the secant and the blade profile, translating the secant to obtain the intersection point of the secant and the pressure surface.

Further, step (1) may include:

(11) collecting blade profile measuring points of the aero-engine blade to form a blade profile measuring point set, and taking a connecting line between two most distant points in the blade profile measuring point set as a secant;
(12) rotating or translating the secant to enable the secant to intersect with a pressure surface at two points, and making a straight line perpendicular to the secant by using a midpoint of a connecting line of the two points to obtain an intersection point of the straight line and the pressure surface; and
(13) segmenting a blade profile by the secant and the intersection point of the straight line and the pressure surface to obtain a leading edge point set and a trailing edge point set.

Further when there are 2 intersection points of the secant and the blade profile, the secant is translated to obtain the intersection point of the secant and the pressure surface.

Further, the threshold $$\delta s = \frac{1}{2 d_{avg}}$$ ($\delta_s = 1 / 2 d_{avg}$), wherein $d_{avg}$ is an average value of a distance between two adjacent points in the blade profile measuring point set.

According to another aspect of the present invention, a system for determining and calculating a profile chord length of an aero-engine blade based on secant rotation iteration is provided. The system includes:

a point set segmentation module, configured to take a connection line between two most disatant points in a blade profile measuring point set as a secant, rotate or translate the secant to enable the secant to intersect with a pressure surface, thus obtaining a leading edge point set and a trailing edge point set; and
a secant rotation module, configured to rotate the secant in a range of the leading edge point set and the trailing edge point set to obtain tangent points of the secant and the leading and trailing edges, and calculate a distance between the two tangent points to obtain a chord length.

Further, the system may include:
a blade performance evaluation module, configured to compare the chord length calculated by the secant rotation module with a standard chord length, wherein when an error between the chord length and the standard chord length is less than a preset value, the aerodynamic performance and safety of the blade meet requirements.

The point set segmentation module may further include:

a first module, configured to collect blade profile measuring points of the aero-engine blade to form a blade profile measuring point set, and take a connecting line between two most distant points in the blade profile measuring point set as a secant;
a second module, configured to rotate or translate the secant to enable the secant to intersect with the pressure surface at two points, and use a midpoint of a connecting line of the two points to make a straight line perpendicular to the secant to obtain an intersection point of the straight line and the pressure surface; and
a third module, configured to segment a blade profile by the secant and the intersection point of the straight line and the pressure surface to obtain a leading edge point set and a trailing edge point set.

In general, compared with the prior art, the above technical solution conceived in the present invention achieves the following beneficial effects.

(1) According to the present invention, the connecting line between the two most distant points in the blade profile measuring point set is taken as the secant, and the secant is rotated or translated to intersect with the pressure surface to divide the point set; the secant is rotated in the range of the point set to obtain the tangent points of the secant and the leading and trailing edges, the distance between the two tangent points is calculated to obtain the chord length, so that the accuracy of the calculated chord length is high. Further the size of the blade can be controlled through the chord length of the blade. If the chord length is too short, the strength of the blade is reduced, the impact resistance and the aerodynamic performance of the blade are further affected, and thus the aerodynamic performance and safety of the blade can be guaranteed when the chord length of the blade is determined through the pesent method.

(2) According to the present invention, the secant and the pressure surface are intersected at two points, the midperpendicular of the two intersection points with the pressure surface is made, and the intersection point between the midperpendicular and the pressure surface is obtained, so that the front edge and trailing edge point sets are divided based on the position relationship between the point and the secant and between the point and the midperpendicular, and are sorted, and finally, a chord line is obtained based on the secant rotation iteration. According to the method based on the secant rotation iteration, the tangent line (chord line) in a direction of the pressure surface is constructed step by step, so that the problem of complex convex hull structure is solved, and the problem of false calculation of the chord length caused by close measuring points when small leading and trailing edge radius measuring points are calculated is avoided.

(3) According to the present application, when the intersection point of the secant and the blade profile is found, $S_i$ is compared with the threshold $\delta s$. The threshold is obtained by the average value of the distance between the two adjacent points in the blade profile measuring point set. The intersection point obtained thereby considers the sparse degree of the points in the blade profile measuring point set, and the leading edge point set and the trailing edge point set segmented thereby are more accurate, so that the found tangent points are more accurate, and the finally detected chord length is more accurate.

## BRIEF DESCRIPTION OF THE DRAWINGS

FIG. 1 is a schematic diagram of a blade profile measuring point of an aero-engine blade according to an embodiment of the present application;
FIG. 2 is a schematic diagram when there are four intersection points of a secant and a blade profile according to an embodiment of the present invention;
FIG. 3 is a schematic diagram when there are three intersection points of a secant and a blade profile according toy an embodiment of the present invention;
FIG. 4 is a schematic diagram when there are two intersection points of a secant and a blade profile according to an embodiment of the present invention;
FIG. 5 is a schematic diagram of a segmented blade profile according toy an embodiment of the present invention;
FIG. 6 is a schematic diagram of a leading edge point set and a trailing edge point set obtained by a segmented blade profile according toy an embodiment of the present invention;
FIG. 7 is a schematic diagram of a rotary secant according to an embodiment of the present invention;
FIG. 8 is a schematic diagram of a first tangent point found by a rotary secant according to an embodiment of the present invention; and
FIG. 9 is a schematic diagram of a second tangent point found by a rotary secant according to an embodiment of the present invention.

## DETAILED DESCRIPTION

To further illustrate the objectives, technical solutions, and advantages of the present invention, the present invention will be further described below in detail with reference to the accompanying drawings and embodiments. It should be understood that the specific embodiments described herein are only used to explain the present invention and are not intended to limit the present invention. In addition, the technical features involved in the various embodiments of the present invention described below can be combined with each other as long as they do not constitute a conflict with each other.

A method for determining and calculating a profile chord length of an aero-engine blade based on secant rotation iteration includes the following steps:

(1) a connection line between two furthermost points in a blade profile measuring point set is taken as a secant, the secant is rotated or translated to intersect with a pressure surface, and thus a leading edge point set and a trailing edge point set are obtained; and
(2) the secant is rotated in a range of the leading edge point set and the trailing edge point set to obtain tangent points of the secant and leading and trailing edges, and a distance between the two tangent points is calculated to obtain a chord length.

**EP 3 913 520 B1**

The method may further include:
the chord length calculated in step (2) is compared with a standard chord length, wherein when a difference between the chord length and the standard chord length is less than a preset value, the aerodynamic performance and safety of the blade meet requirements.

Specifically, step (1) of the present application may include the following steps:

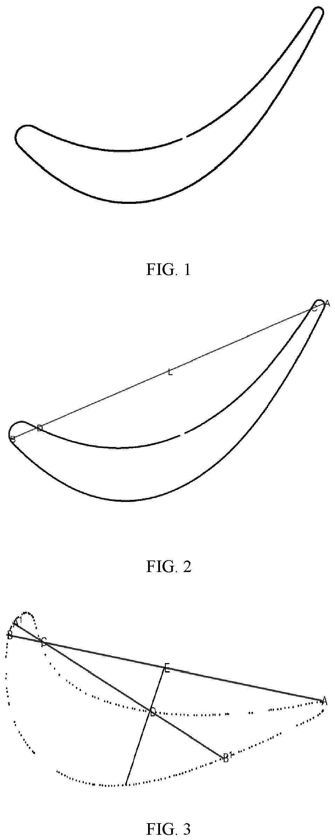

(11) as shown in FIG. 1, blade profile measuring points of the aero-engine blade are collected by a three-coordinate detection measuring machine and a point laser displacement sensor to obtain a blade profile measuring point set, and a connecting line between two most distant points in the blade profile measuring point set is taken as a secant; and by selecting any two points $p_i(x_i, y_i)$ and $p_j(x_j, y_j)$ in the blade profile measuring point set, the distance

$$d_{ij} = \sqrt{(x_i - x_j)^2 + (y_i - y_j)^2}$$

is calculated totally for $n(n + 1)/2$ times to obtain the two most distant points $A(x_a, y_b)$ and $B(x_b, y_b)$, and the two points are connected to obtain a longest secant L of the blade profile, wherein the linear equation of the secant is $(y_b - y_a)(x - x_a) + (x_a - x_b)(y - y_a) = 0$.

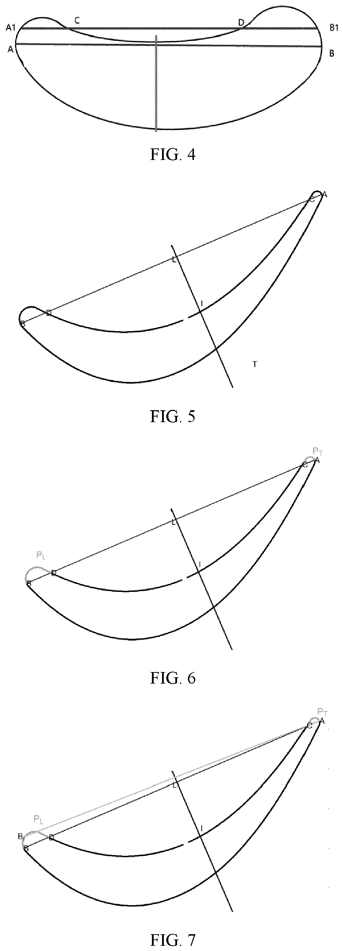

(12) The secant is rotated or translated to intersect with the pressure surface at two points, and the coordinates $(x_i, y_i)$ of any point $p_i$ in the blade profile measuring point set are substituted into the linear equation of the secant to obtain $S_i = (y_b - y_a)(x_i - x_a) + (x_a - x_b)(y_i - y_a)$, wherein $(x_a, y_b)$ and $(x_b, y_b)$ are two endpoints of the secant, and $S_i$ is a value obtained by substituting $p_i$ into the linear equation; $S_i$ is compared with a threshold $\delta s$, wherein the threshold $\delta s = \dfrac{1}{2d_{avg}}$ ($\delta_s = 1 / 2d_{avg}$), and $d_{avg}$ is an average value of the distance between two adjacent points in the blade profile measuring point set; when $S_i$ is less than the threshold $\delta s$, $p_i$ is the intersection point of the secant and the blade profile; there are 2 or 3 or 4 intersection points of the secant and the blade profile; as shown in FIG. 2, when the intersection points of the secant and the blade profile are A, C, D and B, the two middle points C and D are the intersection points of the secant and the pressure surface when the four intersection points are connected; as shown in FIG. 3, when the intersection points of the secant and the blade profile are A, C and B, a straight line passing a midpoint E between the two points A and C is made, a straight line passing the midpoint E is obtained to intersect with the pressure surface at D, the C and D are connected to obtain a secant, the other two intersection points *A'* and *B'* of the secant and the blade profile are calculated, or the point C is fixed and the secant is rotated to obtain the intersection point D of the secant and the pressure surface, and the C and D are taken as the intersection points of the secant and the pressure surface; and as shown in FIG. 4, when there are two intersection points of the secant and the blade profile, the secant is translated along a midperpendicular direction of the two points A and B until the secant is intersected with the blade profile at four points, wherein the points C and D are the intersection points of the secant and the pressure surface.
Firstly, a straight line T is made by passing a midpoint $E(x_e, y_e)$ of the intersection points $C(x_c, y_c)$ and $D(x_d, y_d)$ of the secant L and the pressure surface and is perpendicular to the secant L, the linear equation is $(y_b - y_a)(y - y_e) + (x_b - x_a)(x - x_e) = 0$, then the intersection point of the straight line T and the blade profile is calculated, that is, any point $p_i(x_l, y_l)$ in the blade profile is substituted into the linear equation to obtain $d_i = (y_b - y_a)(y_i - y_e) + (x_b - x_a)(x_i - x_e)$ so as to obtain two intersection points *I* and *I'*, then the distance from the points I and I' to the secant L is calculated, as shown in FIG. 5, the closer intersection point is the intersection point I of the straight line T and the pressure surface.

(13) The blade profile is segmented by the secant and the intersection point of the straight line and the pressure surface to obtain the leading edge point set and the trailing edge point set.

As shown in FIG. 6, the secant L divides the blade profile into two parts, the two parts and the point I can fall on the same side of the secant L and fall on the different sides of the secant L. Based on the above position relationship, the blade profile can be divided into two parts $P_{same} = \{p_i(x_i, y_i) \in P | ((y_b - y_a)(x_i - x_a) + (x_a - x_b)(y_i - y_a)) \cdot S_l > 0\}$ and $P_{vary} = \{p_i(x_i, y_i) \in P | ((y_b - y_a)(x_i - x_a) + (x_a - x_b)(y_i - y_a)) \cdot S_l \leq 0$, wherein $S_l = (y_b - y_a)(x_l - x_a) + (x_a - x_b)(y_l - y_a)$. Then based on the position relationship between the point $p_i$ and the straight line T, the point set $P_{vary}$ can be divided into a leading edge point set $P_l = \{p_i(x_i, y_i) \in P_{vary} | (y_b - y_a)(y_i - y_e) + (x_b - x_a)(x_i - x_e) < 0\}$ and a trailing edge point set

$$P_t = \{p_i(x_i, y_i) \in P_{vary} | (y_b - y_a)(y_i - y_e) + (x_b - x_a)(x_i - x_e) > 0\}.$$

Step (2) may include:

(21) the leading edge point set is sorted according to a distance between points in the leading edge point set and the straight line, and the trailing edge point set is sorted according to a distance between points in the trailing edge point set and the straight line;

(22) fixing an endpoint of the secant, and sequentially rotating the secant according to a sorting result in the trailing edge point set to obtain a tangent point of the secant and the trailing edge; and

(23) fixing the tangent point of the secant and the trailing edge, sequentially rotating the secant according to a sorting result in the leading edge point set to obtain a tangent point of the secant and the leading edge, and calculating a distance between the two tangent points to obtain a chord length.

Alternatively step (2) may include:

(21) the leading edge point set is sorted according to a distance between points in the leading edge point set and the straight line, and the trailing edge point set is sorted according to a distance between points in the trailing edge point set and the straight line;

(22) fixing an endpoint of the secant, and sequentially rotating the secant according to a sorting result in the leading edge point set to obtain a tangent point of the secant and the leading edge; and

(23) the tangent point of the secant and the leading edge is fixed, the secant is sequentially rotated according to a sorting result in the trailing edge point set to obtain a tangent point of the secant and the trailing edge, and a distance between the two tangent points is calculated to obtain a chord length.

The present invention takes one of the above as an example for detailed description.

Firstly, a distance $d_i = \frac{(y_b - y_a)(y - y_e) + (x_b - x_a)(x - x_e)}{\sqrt{(y_b - y_a)^2 + (x_b - x_a)^2}}$ from any point $p_i$ of $P_l$ and $P_t$ to the straight line $T$ is calculated, and then the values of $|d_i|$ are sorted from the largest to the smallest to obtain an ordered leading edge point set $P_l' = \{A, A_1, A_2, ..., A_m\}$ and an ordered trailing edge point set $P_t' = \{B, B_1, B_2, ..., B_n\}$.

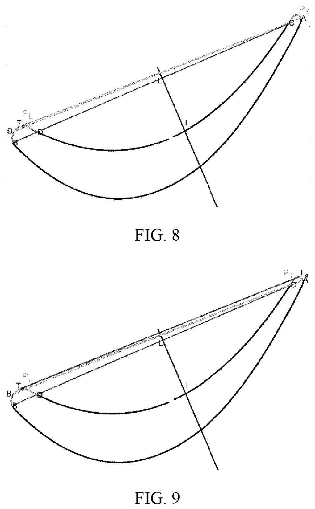

As shown in FIG. 7, the point A is firstly fixed, the point A and the point $B_i(x_{b_i}, y_{b_i})$ are sequentially connected to obtain a new secant $L_{B_i}$, the linear equation of the secant $L_{B_i}$ is $(y_{b_i} - y_a)(x - x_a) + (x_a - x_{b_i})(y - y_a) = 0$, whether a midpoint $p_i$ of the $P_t'$ falls on one side of $L_B$ with the point I is judged, that is, whether $((y_{b_i} - y_a)(x_i - x_a) + (x_a - x_{b_i})(y_i - y_\alpha)) \cdot ((y_{b_i} - y_a)(x_i - x_a) + (x_a - x_{b_i})(y_i - y_\alpha)) > 0$ is true or not is judged, if the point $B_i$ is not true, a new secant $L_{B_{i+1}}$ is continuously constructed, otherwise, iteration is stopped to obtain a secant $L_{B_i}$, such that all points in $P_l'$ fall on one side of the secant with the point I, and at the moment, $B_i$ is the tangent point $T_e$ of the chord line and the trailing edge, as shown in FIG. 8.

As shown in FIG. 9, firstly, a tangent point $T_e$ of the trailing edge is fixed, a point $T_e$ and a point $A_i(x_{a_i}, y_{a_i})$ are sequentially connected to obtain a new secant $L_{A_i}$, the linear equation of the secant $L_{A_i}$ is $(y_{te} - y_{a_i})(x - x_{a_i}) + (x_{a_i} - x_{te})(y - y_{a_i}) = 0$, whether a midpoint $p_i$ falls on one side of $L_{A_i}$ with the point I is determined, that is, whether $((y_{te} - y_{a_i})(x_i - x_{a_i}) + (x_{a_i} - x_{te})(y_i - y_{a_i})) \cdot ((y_{te} - y_{a_i})(x_i - x_{a_i}) + (x_{a_i} - x_{te})(y_i - y_{a_i})) > 0$ is true or not is determined, if the point $A_i$ is not true, a new secant $L_{A_i}$ is continuously constructed, otherwise, iteration is stopped to obtain a secant $L_{A_i}$, such that all the points in $P_t'$ fall on one side of the secant with the point I, at the moment, $A_i$ is the tangent point $L_e$ of the chord line and the trailing edge, and the distance between the tangent points $T_e(x_{te}, y_{te})$ and $L_e(x_{le}, y_{le})$ is calculated, that is, the chord length $d = \sqrt{(x_{te} - x_{le})^2 + (y_{te} - y_{le})^2}$.

The method of the present invention is suitable for calculating the profile chord length of various types of aero-engine blades, that is, calculating the profile chord length of the aero-engine blade based on secant rotation iteration.

It is clear for those skilled in the art that the above are only preferred embodiments of the present invention, and these are not intended to limit the present invention. Any modifications, equivalent substitutions and improvements and the like made within the principles of the present invention should fall within the protection scope of the present invention as defined in the appended claims.

## Claims

1.   A method for determining and calculating a profile chord length of an aero-engine blade based on secant rotation iteration, comprising the following steps:

(1) taking a connection line between two most distant points in a blade profile measuring point set as a secant, rotating or translating the secant to enable the secant to intersect with a pressure surface, thus obtaining a leading edge point set and a trailing edge point set; and

(2) rotating the secant in a range of the leading edge point set and the trailing edge point set to obtain tangent points of the secant and leading and trailing edges, and calculating a distance between the two tangent points to obtain a chord length; **characterized by** further comprising:

comparing the chord length calculated in the step (2) with a standard chord length, wherein when an error between the chord length and the standard chord length is less than a preset value, the aerodynamic performance and safety of the blade meet requirements; wherein step (2) comprises:

(21) sorting the leading edge point set according to a distance between points in the leading edge point set and the straight line, and sorting the trailing edge point set according to a distance between points in the trailing edge point set and the straight line;
(22) fixing an endpoint of the secant, and sequentially rotating the secant according to a sorting result in the trailing edge point set to obtain a tangent point of the secant and the trailing edge; and
(23) fixing the tangent point of the secant and the trailing edge, sequentially rotating the secant according to a sorting result in the leading edge point set to obtain a tangent point of the secant and the leading edge, and calculating a distance between the two tangent points to obtain a chord length;

wherein in the step (1) of rotating or translating the secant to enable the secant to intersect with the pressure surface, is specifically implemented as follows:
substituting coordinates $(x_i, y_i)$ of any point $p_i$ in the blade profile measuring point set into a linear equation of the secant to obtain $S_i = (y_b - y_a)(x_i - x_a) + (x_a - x_b)(y_i - y_a)$, *wherein* $(x_a, y_b)$ and $(x_b, y_b)$ are two endpoints of the secant, and $S_i$ is a value obtained by substituting $p_i$ into the linear equation; comparing $S_i$ with a threshold $\delta s$, and when $S_i$ is less than the threshold $\delta s$, taking $p_i$ as the intersection point of the blade profile; intersection points of the secant and the blade profile being 2 or 3 or 4; when there are 4 intersection points of the secant and the blade profile, two middle points when the four intersection points are connected are the intersection points of the secant and the pressure surface; when there are 3 intersection points of the secant and the blade profile, rotating the secant to obtain the intersection point of the secant and the pressure surface; and when there are 2 intersection points of the secant and the blade profile, translating the secant to obtain the intersection point of the secant and the pressure surface.

2. The method for determining and calculating the profile chord length of the aero-engine blade based on secant rotation iteration according to claim 1, **characterized in that** the step (1) comprises:

(11) collecting blade profile measuring points of the aero-engine blade to form a blade profile measuring point set, and taking a connecting line between two most distant points in the blade profile measuring point set as a secant;
(12) rotating or translating the secant to enable the secant to intersect with a pressure surface at two points, and making a straight line perpendicular to the secant by using a midpoint of a connecting line of the two points to obtain an intersection point of the straight line and the pressure surface; and
(13) segmenting a blade profile by the secant and the intersection point of the straight line and the pressure surface to obtain a leading edge point set and a trailing edge point set.

3. The method for determining and calculating the profile chord length of the aero-engine blade based on secant rotation iteration according to claim 1, **characterized in that** the threshold $\delta s = \dfrac{1}{2d_{avg}}$, wherein $d_{avg}$ is an average value of a distance between two adjacent points in the blade profile measuring point set.

4. The method for determining and calculating the profile chord length of the aero-engine blade based on secant rotation iteration according to claim 2 or 3, **characterized in that** the step (2) comprises:

(21) sorting the leading edge point set according to a distance between points in the leading edge point set and the straight line, and sorting the trailing edge point set according to a distance between points in the trailing edge point set and the straight line;
(22) fixing an endpoint of the secant, and sequentially rotating the secant according to a sorting result in the leading edge point set to obtain a tangent point of the secant and the leading edge; and
(23) fixing the tangent point of the secant and the leading edge, sequentially rotating the secant according to a sorting result in the trailing edge point set to obtain a tangent point of the secant and the trailing edge, and calculating a distance between the two tangent points to obtain a chord length.

**5.** A system for determining and calculating a profile chord length of an aero-engine blade based on secant rotation iteration according to the method of claims 1-4, **characterized by** comprising:
a point set segmentation module, configured to take a connection line between two most distant points in a blade profile measuring point set as a secant, and rotate or translate the secant to enable the secant to intersect with a pressure surface so as to obtain a leading edge point set and a trailing edge point set; and
a secant rotation module, configured to rotate the secant in a range of the leading edge point set and the trailing edge point set to obtain tangent points of the secant and a leading edge and a trailing edge, and calculate a distance between the two tangent points to obtain a chord length.

**6.** The system for determining and calculating the profile chord length of the aero-engine blade based on secant rotation iteration according to claim 5, **characterized by** further comprising:
a blade performance evaluation module, configured to compare the chord length calculated by the secant rotation module with a standard chord length, wherein when an error between the chord length and the standard chord length is less than a preset value, the aerodynamic performance and safety of the blade meet requirements.

**7.** The system for determining and calculating the profile chord length of the aero-engine blade based on secant rotation iteration according to claim 5 or 6, **characterized in that** the point set segmentation module comprises:

a first module, configured to collect blade profile measuring points of the aero-engine blade to form a blade profile measuring point set, and take a connecting line between two most distant points in the blade profile measuring point set as a secant;
a second module, configured to rotate or translate the secant to enable the secant to intersect with a pressure surface at two points, and use a midpoint of a connecting line of the two points to make a straight line perpendicular to the secant to obtain an intersection point of the straight line and the pressure surface; and
a third module, configured to segment a blade profile by the secant and the intersection point of the straight line and the pressure surface to obtain a leading edge point set and a trailing edge point set.


**Patentansprüche**

**1.** Verfahren zum Bestimmen und Berechnen einer Profilsehnenlänge einer Flugzeugtriebwerksschaufel auf der Grundlage einer Sekantenrotationsiteration, welches die Schritte umfasst:

(1) Nehmen einer Verbindungslinie zwischen zwei am weitesten entfernten Punkten in einem Schaufelprofilmesspunktsatz als eine Sekante, Drehen oder Verschieben der Sekante, so dass sich die Sekante mit einer Druckfläche schneiden kann, wodurch ein Vorderkantenpunktesatz und ein Hinterkantenpunktesatz erhalten wird; und
(2) Drehen der Sekante in einem Bereich des Vorderkantenpunktesatzes und des Hinterkantenpunktesatzes, um Tangentenpunkte der Sekante und der Vorder- und Hinterkanten zu erhalten, und Berechnen eines Abstandes zwischen den beiden Tangentenpunkten, um eine Sehnenlänge zu erhalten; **dadurch gekennzeichnet, dass** das Verfahren ferner umfasst:

Vergleichen der in Schritt (2) berechneten Sehnenlänge mit einer Standardsehnenlänge, wobei, wenn ein Fehler zwischen der Sehnenlänge und der Standardsehnenlänge kleiner als ein voreingestellter Wert ist, die aerodynamische Leistung und die Sicherheit der Schaufel die Anforderungen erfüllen;
wobei Schritt (2) umfasst:

(21) Sortieren des Vorderkantenpunktesatzes gemäß einem Abstand zwischen Punkten in dem Vorderkantenpunktesatz und der geraden Linie, und Sortieren des Hinterkantenpunktesatzes gemäß einem Abstand zwischen Punkten in dem Hinterkantenpunktesatz und der geraden Linie;
(22) Fixieren eines Endpunktes der Sekante und sequentielles Drehen der Sekante gemäß einem Sortierergebnis in dem Hinterkantenpunktesatz, um einen Tangentenpunkt der Sekante und der Hinterkante zu erhalten; und
(23) Fixieren des Tangentenpunktes der Sekante und der Hinterkante, sequentielles Drehen der Sekante gemäß einem Sortierergebnis in dem Vorderkantenpunktesatz, um einen Tangentenpunkt der Sekante und der Vorderkante zu erhalten, und Berechnen eines Abstandes zwischen den beiden Tangentenpunkten, um eine Sehnenlänge zu erhalten;

wobei in dem Schritt (1) des Drehens oder Verschiebens der Sekante, um zu ermöglichen, dass die Sekante die Druckfläche schneidet, wie folgt ausgeführt wird:

Ersetzen von Koordinaten $(x_i, y_i)$ eines beliebigen Punktes $p_i$ im Messpunkt des Schaufelprofils eingesetzt in eine lineare Gleichung der Sekante, um zu erhalten: $S_i = (y_b - y_a)(x_i - x_a) + (x_a - x_b)(y_i - y_a)$, wobei $(x_a, y_b)$ und $(x_b, y_b)$ zwei Endpunkte der Sekante sind, und $S_i$ ein Wert ist, der erhalten wird durch Ersetzen von $p_i$ in die lineare Gleichung; Vergleichen von $S_i$ mit einem Schwellenwert $\delta s$, und wenn $S_i$ kleiner ist als der Schwellenwert $\delta s$, Nehmen von $p_i$ als den Schnittpunkt des Schaufelprofils; wobei die Schnittpunkte der Sekante und des Schaufelprofils 2 oder 3 oder 4 sind; wobei, wenn es 4 Schnittpunkte der Sekante und des Schaufelprofils gibt und wenn diese vier Schnittpunkte verbunden sind, zwei mittlere Punkte die Schnittpunkte der Sekante und der Druckfläche sind; wobei, wenn es 3 Schnittpunkte der Sekante und des Schaufelprofils gibt, eine Rotation der Sekante erfolgt, um den Schnittpunkt der Sekante und der Druckfläche zu erhalten; und wobei, wenn es 2 Schnittpunkte der Sekante und des Schaufelprofils gibt, ein Verschieben der Sekante erfolgt, um den Schnittpunkt der Sekante und der Druckfläche zu erhalten.

2. Verfahren zum Bestimmen und Berechnen der Profilsehnenlänge der Flugzeugtriebwerksschaufel auf der Grundlage einer Sekantenrotationsiteration nach Anspruch 1, **dadurch gekennzeichnet, dass** der Schritt (1) umfasst:

(11) Sammeln von Schaufelprofilmesspunkten der Flugzeugtriebwerksschaufel, um einen Schaufelprofilmesspunktsatz zu bilden, und Nehmen einer Verbindungslinie zwischen zwei am weitesten entfernten Punkten in dem Schaufelprofilmesspunktsatz als Sekante;

(12) Drehen oder Verschieben der Sekante, um zu ermöglichen, dass sich die Sekante mit einer Druckfläche an zwei Punkten schneidet, und Herstellen einer geraden Linie senkrecht zu der Sekante durch Verwenden eines Mittelpunkts einer Verbindungslinie der zwei Punkte, um einen Schnittpunkt der geraden Linie und der Druckfläche zu erhalten; und

(13) Segmentieren eines Schaufelprofils durch die Sekante und den Schnittpunkt der Geraden und der Druckfläche, um einen Vorderkantenpunktesatz und einen Hinterkantenpunktesatz zu erhalten.

3. Verfahren zum Bestimmen und Berechnen der Profilsehnenlänge der Flugzeugtriebwerksschaufel auf der Grundlage einer Sekantenrotationsiteration nach Anspruch 1, **dadurch gekennzeichnet, dass** der Schwellenwert $\delta s = \dfrac{1}{2 d_{avg}}$ ist, wobei $d_{avg}$ ein Durchschnittswert eines Abstandes zwischen zwei benachbarten Punkten auf dem Schaufelprofilmesspunktsatz ist.

4. Verfahren zum Bestimmen und Berechnen der Profilsehnenlänge der Flugzeugtriebwerksschaufel auf der Grundlage einer Sekantenrotationsiteration nach Anspruch 2 oder 3, **dadurch gekennzeichnet, dass** der Schritt (2) umfasst:

(21) Sortieren des Vorderkantenpunktesatzes gemäß einem Abstand zwischen Punkten im Vorderkantenpunktesatz und der geraden Linie, und Sortieren des Hinterkantenpunktesatzes gemäß einem Abstand zwischen Punkten im Hinterkantenpunktesatz und der geraden Linie;

(22) Fixieren eines Endpunktes der Sekante und sequentielles Drehen der Sekante gemäß einem Sortierergebnis in dem Vorderkantenpunktesatz, um einen Tangentenpunkt der Sekante und der Vorderkante zu erhalten; und

(23) Fixieren des Tangentenpunktes der Sekante und der Vorderkante, sequentielles Drehen der Sekante gemäß einem Sortierergebnis in dem Hinterkantenpunktesatz, um einen Tangentenpunkt der Sekante und der Hinterkante zu erhalten, und Berechnen eines Abstandes zwischen den beiden Tangentenpunkten, um eine Sehnenlänge zu erhalten.

5. System zum Bestimmen und Berechnen einer Profilsehnenlänge einer Flugzeugtriebwerksschaufel auf der Grundlage einer Sekantenrotationsiteration nach dem Verfahren der Ansprüche 1-4, **dadurch gekennzeichnet, dass** es umfasst:

ein Punktesatzsegmentierungsmodul, das konfiguriert ist, eine Verbindungslinie zwischen zwei am weitesten entfernten Punkten in einem Schaufelprofilmesspunktsatz als eine Sekante zu nehmen und die Sekante zu drehen oder zu verschieben, um zu ermöglichen, dass sich die Sekante mit einer Druckfläche schneidet, um einen Vorderkantenpunktesatz und einen Hinterkantenpunktesatz zu erhalten; und

ein Sekantenrotationsmodul, das konfiguriert ist, die Sekante in einem Bereich des Vorderkantenpunktesatzes und des Hinterkantenpunktesatzes zu drehen, um Tangentenpunkte der Sekante und einer Vorderkante und einer Hinterkante zu erhalten, und einen Abstand zwischen den beiden Tangentenpunkten zu berechnen, um eine Sehnenlänge zu erhalten.

**6.** System zum Bestimmen und Berechnen der Profilsehnenlänge der Flugzeugtriebwerksschaufel auf der Grundlage einer Sekantenrotationsiteration nach Anspruch 5, **dadurch gekennzeichnet, dass** es ferner umfasst:

ein Modul zur Bewertung der Schaufelleistung, das konfiguriert ist, die von dem Sekantenrotationsmodul berechnete Sehnenlänge mit einer Standardsehnenlänge zu vergleichen, wobei die aerodynamische Leistung und die Sicherheit der Schaufel die Anforderungen erfüllen, wenn ein Fehler zwischen der Sehnenlänge und der Standardsehnenlänge kleiner als ein vorgegebener Wert ist.

**7.** System zum Bestimmen und Berechnen der Profilsehnenlänge der Flugzeugtriebwerksschaufel auf der Grundlage einer Sekantenrotationsiteration nach Anspruch 5 oder 6, **dadurch gekennzeichnet, dass** das Punktesatzsegmentierungsmodul umfasst:

ein erstes Modul, das konfiguriert ist, Schaufelprofilmesspunkte der Flugzeugtriebwerksschaufel zu sammeln, um einen Schaufelprofilmesspunktesatz zu bilden, und eine Verbindungslinie zwischen zwei am weitesten entfernten Punkten in dem Schaufelprofilmesspunktesatz als eine Sekante zu nehmen;
ein zweites Modul, das konfiguriert ist, die Sekante zu drehen oder zu verschieben, um zu ermöglichen, dass sich die Sekante mit einer Druckfläche an zwei Punkten schneidet, und einen Mittelpunkt einer Verbindungslinie der zwei Punkte zu verwenden, um eine gerade Linie senkrecht zu der Sekante zu bilden, um einen Schnittpunkt der geraden Linie und der Druckfläche zu erhalten; und
ein drittes Modul, das konfiguriert ist, ein Schaufelprofil durch die Sekante und den Schnittpunkt der Geraden und der Druckfläche zu segmentieren, um einen Vorderkantenpunktesatz und einen Hinterkantenpunktesatz zu erhalten.

## Revendications

**1.** Méthode de détermination et de calcul d'une longueur de corde de profil d'une pale de moteur d'avion basée sur l'itération de la rotation de la sécante, comprenant les étapes suivantes:

(1) prendre une ligne de connexion entre deux points les plus éloignés dans un ensemble de points de mesure du profil de la pale comme une sécante, tourner ou translater la sécante pour permettre à la sécante de croiser une surface de pression, obtenant ainsi un ensemble de points de bord d'attaque et un ensemble de points de bord de fuite; et
(2) tourner la sécante dans une plage de l'ensemble de points du bord d'attaque et du bord de fuite pour obtenir des points tangents de la sécante et des bords d'attaque et de fuite, et calculer une distance entre les deux points tangents pour obtenir une longueur de corde; **caractérisé en ce qu'**il comprend en outre:

comparer la longueur de corde calculée à l'étape (2) avec une longueur de corde standard, dans laquelle lorsqu'une erreur entre la longueur de corde et la longueur de corde standard est inférieure à une valeur prédéfinie, la performance aérodynamique et la sécurité de la pale répondent aux exigences; dans laquelle l'étape (2) comprend:

(21) trier l'ensemble de points du bord d'attaque en fonction de la distance entre les points de l'ensemble de points du bord d'attaque et la ligne droite, et trier l'ensemble de points de bord de fuite en fonction de la distance entre les points de l'ensemble de points de bord de fuite et la ligne droite;
(22) fixer un point final de la sécante et tourner séquentiellement la sécante en fonction d'un résultat de tri dans l'ensemble de points de bord de fuite pour obtenir un point de tangence de la sécante et du bord de fuite; et
(23) fixer le point tangent de la sécante et du bord de fuite, faire tourner séquentiellement la sécante en fonction d'un résultat de tri dans l'ensemble de points du bord d'attaque pour obtenir un point tangent de la sécante et du bord d'attaque, et calculer une distance entre les deux points tangents pour obtenir une longueur de corde;

dans lequel l'étape (1) de tourner ou de translater la sécante pour permettre à la sécante de croiser la surface de pression est spécifiquement mise en œuvre comme suit:
substituer les coordonnées $(x_i, y_i)$ de tout point $p_i$ de l'ensemble de points de mesure du profil de la pale dans une équation linéaire de la sécante pour obtenir $S_i = (y_b - y_a)(x_i - x_\alpha) + (x_a - x_b)(y_i - y_a)$, où $(x_a, y_b)$ et $(x_b, y_b)$ sont deux extrémités de la sécante, et $S_i$est une valeur obtenue en substituent $p_i$ dans l'équation linéaire; comparer $S_i$ à un seuil $\delta s$, et lorsque $S_i$ est inférieur au seuil $\delta s$, prendre $p_i$ as le point d'intersection du profil de la pale; les points d'intersection de la sécante et du profil de la pale étant 2 ou 3 ou 4; lorsqu'il y a 4 points d'intersection de la sécante et du profil de la pale, deux points centraux lorsque les quatre points d'intersection sont reliés sont les points d'intersection de la sécante et de la surface de pression; lorsqu'il y a 3 points d'intersection de la sécante et du profil de la pale, tourner la sécante pour obtenir le point d'intersection de la sécante et de la surface de pression; et lorsqu'il y a 2 points d'intersection de la sécante et du profil de la pale, translation de la sécante pour obtenir le point d'intersection de la sécante et de la surface de pression.

2. Méthode de détermination et de calcul de la longueur de corde du profil de la pale de moteur d'avion basée sur l'itération de la rotation sécante selon la revendication 1, **caractérisée en ce que** l'étape (1) comprend:

   (11) collecter des points de mesure du profil de la pale de la pale du moteur d'avion pour former un ensemble de points de mesure du profil de la pale, et prendre une ligne de connexion entre deux points les plus éloignés dans l'ensemble de points de mesure du profil de la pale comme une sécante;
   (12) tourner ou translation de la sécante pour permettre à la sécante de croiser une surface de pression en deux points, et établissement d'une ligne droite perpendiculaire à la sécante en utilisant un point médian d'une ligne de connexion des deux points pour obtenir un point d'intersection de la ligne droite et de la surface de pression; et
   (13) segmenter un profil de pale par la sécante et le point d'intersection de la ligne droite et de la surface de pression pour obtenir un ensemble de points de bord d'attaque et un ensemble de points de bord de fuite.

3. Méthode de détermination et de calcul de la longueur de corde du profil de la pale de moteur d'avion basé sur l'itération de la rotation sécante selon la revendication 1, **caractérisé en ce que** le seuil $\delta s = \dfrac{1}{2 d_{avg}}$, où $d_{avg}$ est une valeur moyenne d'une distance entre deux points adjacents dans l'ensemble de points de mesure du profil de la pale.

4. Méthode de détermination et de calcul de la longueur de corde du profil de la pale de moteur d'avion basé sur l'itération de la rotation sécante selon la revendication 2 ou 3, **caractérisé en ce que** l'étape (2) comprend:

   (21) trier l'ensemble de points du bord d'attaque en fonction de la distance entre les points de l'ensemble de points du bord d'attaque et la ligne droite, et trier l'ensemble de points de bord de fuite en fonction de la distance entre les points de l'ensemble de points de bord de fuite et la ligne droite;
   (22) fixer un point final de la sécante et tourner séquentiellement la sécante en fonction d'un résultat de tri dans l'ensemble de points du bord d'attaque pour obtenir un point de tangence de la sécante et du bord d'attaque; et
   (23) fixer le point tangent de la sécante et du bord d'attaque, tourner séquentiellement la sécante en fonction d'un résultat de tri dans l'ensemble de points de bord de fuite pour obtenir un point tangent de la sécante et du bord de fuite, et calculer une distance entre les deux points tangents pour obtenir une longueur de corde.

5. Système de détermination et de calcul d'une longueur de corde de profil d'une pale de moteur d'avion basé sur l'itération de la rotation de la sécante selon la méthode des revendications 1 à 4, **caractérisé par le fait qu'**il comprend:

   un module de segmentation de l'ensemble de points, configuré pour prendre une ligne de connexion entre deux points les plus éloignés dans un ensemble de points de mesure du profil de la pale comme une sécante, et tourner ou translater la sécante pour permettre à la sécante de croiser une surface de pression afin d'obtenir un ensemble de points de bord d'attaque et un ensemble de points de bord de fuite; et
   un module de rotation de la sécante, configuré pour faire tourner la sécante dans une plage de l'ensemble de points du bord d'attaque et de l'ensemble de points de bord de fuite afin d'obtenir des points tangents de la sécante et un bord d'attaque et un bord de fuite, et de calculer une distance entre les deux points tangents afin d'obtenir une longueur de corde.

6. Système de détermination et de calcul d'une longueur de corde de profil d'une pale de moteur d'avion basé sur l'itération de la rotation sécante selon la revendication 5, **caractérisé par le fait qu'**il comprend en outre:
   un module d'évaluation des performances de la pale, configuré pour comparer la longueur de corde calculée par le module de rotation sécante avec une longueur de corde standard, dans lequel lorsqu'une erreur entre la longueur de corde et la longueur de corde standard est inférieure à une valeur prédéfinie, les performances aérodynamiques et la sécurité de la pale répondent aux exigences.

7. Système de détermination et de calcul d'une longueur de corde de profil d'une pale de moteur d'avion basé sur l'itération de la rotation sécante selon la revendication 5 ou 6, **caractérisé en ce que** le module de segmentation de l'ensemble de points comprend:

un premier module, configuré pour collecter les points de mesure du profil de la pale de la pale du moteur d'avion pour former un ensemble de points de mesure du profil de la pale, et prendre une ligne de connexion entre deux points les plus éloignés dans l'ensemble de points de mesure du profil de la pale comme une sécante;

un deuxième module, configuré pour faire tourner ou translater la sécante afin de permettre à la sécante de croiser une surface de pression en deux points, et utiliser un point médian d'une ligne de connexion des deux points pour créer une ligne droite perpendiculaire à la sécante afin d'obtenir un point d'intersection de la ligne droite et de la surface de pression; et

un troisième module, configuré pour segmenter un profil de pale par la sécante et le point d'intersection de la ligne droite et de la surface de pression afin d'obtenir un ensemble de points de bord d'attaque et un ensemble de points de bord de fuite.

FIG. 1

FIG. 2

FIG. 3

FIG. 4

FIG. 5

FIG. 6

FIG. 7

FIG. 8

FIG. 9

**EP 3 913 520 B1**

**REFERENCES CITED IN THE DESCRIPTION**

**Patent documents cited in the description**

• US 2007025855 A